Europäisches Patentamt

European Patent Office

Office européen des brevets

(11) Publication number: **0 519 608 A1**

# EUROPEAN PATENT APPLICATION

(21) Application number: **92304604.9**

(22) Date of filing: **20.05.92**

(51) Int. Cl.5: **C30B 25/12**, C23C 16/44

(30) Priority: **31.05.91 US 708959**

(43) Date of publication of application:
**23.12.92 Bulletin 92/52**

(84) Designated Contracting States:
**DE FR GB**

(71) Applicant: **AMERICAN TELEPHONE AND TELEGRAPH COMPANY**
**550 Madison Avenue**
**New York, NY 10022(US)**

(72) Inventor: **Lum, Richard Melvin**
**30 Raven Road**
**Colts Neck, New Jersey 07722(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) **Substrate holder of thermally anisotropic material used for enhancing uniformity of grown epitaxial layers.**

(57) Applicant has discovered that a wafer disposed on a heated susceptor in a conventional epitaxial growth reactor exhibits a radially symmetric variation in temperature which cannot be removed by rotation alone. Based upon this discovery, applicant has determined that by thermally coupling the wafer to a high conductivity surface of a thermally anisotropic susceptor, one can substantially eliminate the observed radial variation in temperature and thereby enhance the uniformity of the grown epitaxial layer. In a preferred embodiment, the wafer (17) is disposed in thermal contact with rotatable susceptor disc of pyrolytic graphite (20) located in the central region of a heated susceptor block (12).

FIG. 5

## Field of the Invention

This invention relates to growth of epitaxial layers on semiconductor substrates and, in particular, to an apparatus and a method for enhancing the uniformity of grown epitaxial layers.

## Background of the Invention

Epitaxial growth is important in the manufacture of semiconductor devices such as multiquantum well lasers, photonic arrays and long haul transmission lasers. In a typical epitaxial growth process, a semiconductor wafer is placed within a low pressure reactor chamber and heated to a desired temperature. A mixture of reactant gases, such as metalorganic and hydride gases, are flowed over the heated wafer. The mixture reacts at the heated wafer surface, producing epitaxial growth.

One difficulty with conventional epitaxial growth processes and apparatus is nonuniformity of growth. High yield production of semiconductor device chips requires uniform epitaxial growth over the full area of 2 and 3 inch diameter wafers. For certain critical device applications such as multiquantum well lasers, variations in epilayer thickness, composition and doping must be controlled to within tolerances of ±2% or even better. Unfortunately conventional growth processes such as metalorganic chemical vapor deposition (MOCVD) with commercially available equipment do not meet these required tolerances. For example, in MOCVD processes large deviations in film thickness exceeding 5% are observed across two inch diameter wafers, both in the direction of flow of reactant gases and in the direction transverse to gas flow.

A variety of techniques have been employed in an effort to enhance growth uniformity with only small success. For example, on the theory that non-uniform deposition rates in the flow direction occur because of depletion of reactant species, gas flow conditions have been modified by use of either a quartz baffle plate or a tilted susceptor to minimize depletion effects. The result was only a marginal improvement in thickness uniformity. Attempts to improve uniformity by varying the total flow rate, pressure, temperature and gas composition were similarly ineffective.

Another approach is to modify the reactor to provide for substrate rotation during the growth process. Reactors having gas driven systems for rotating the wafer produce an improvement in thickness uniformity but nonetheless exhibit local variations in thickness exceeding 5%. Accordingly, there is a need for enhancing the uniformity of grown epitaxial layers.

## Summary of the Invention

Applicant has discovered that a wafer disposed on a heated susceptor in a conventional epitaxial growth reactor exhibits a radially symmetric variation in temperature which cannot be removed by rotation alone. Based upon this discovery, applicant has determined that by thermally coupling the wafer to a high conductivity surface of a thermally anisotropic susceptor, one can substantially eliminate the observed radial variation in temperature and thereby enhance the uniformity of the grown epitaxial layer. In a preferred embodiment, the wafer is disposed in thermal contact with rotatable susceptor disc of pyrolytic graphite located in the central region of a heated susceptor block.

## Brief Description of the Drawing

In the drawings:
FIG. 1 is a schematic side view of a conventional MOCVD reactor;
FIG. 2 is a schematic end view of the conventional reactor of FIG. 1;
FIG. 3 is a graphical illustration showing the temperature at various points on a stationary graphite disc disposed upon a main susceptor block;
FIG. 4 is a graphical illustration showing the temperature at various points on a rotating graphite disc;
FIG. 5 is a schematic side view of a modified susceptor;
FIG. 6 is a top view of the modified susceptor of FIG. 5;
FIG. 7 is a graphical illustration comparing the temperature uniformity of a susceptor having a rotating pyrolytic graphite disc with one having a rotating disc of ordinary graphite;
FIG. 8 is a schematic cross section of a second modified susceptor;
FIG. 9 is a schematic cross section of a third modified susceptor;
FIG. 10 is a schematic cross section of a fourth modified susceptor.

## Detailed Description

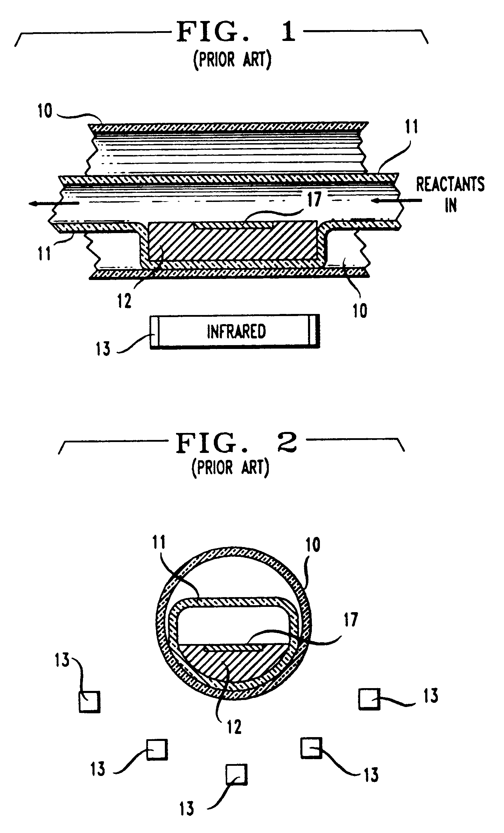

Referring to the drawings, FIGS. 1 and 2 are schematic side and end views, respectively, of a conventional low pressure MOCVD horizontal reactor useful in understanding applicant's modifications of apparatus and method. In essence, the conventional MOCVD reactor comprises an evacuatable outer vessel 10 such as a fused quartz cylindrical tube and an inner cell 11, which can be a rectangular fused quartz tube including a graphite susceptor block 12. A bank of infrared lamps 13 are located around the bottom portion of the cylindrical tube 10 and controlled by a thermocouple (not shown) embedded in susceptor block 12. Separate gas inlet fines (not shown) are provided at one end of tube 10 for metalorganic and hydride reactants, respectively, and an outlet line (not shown) is provided at the other end.

The primary function of vessel 10 is to enable reactor operation at low pressure. The inner rectangular cell 11 is to ensure development of a laminar flow field in the area of the susceptor block 12. The lamps 13 heat susceptor 12 to a desirably uniform temperature, and susceptor 12 supports and desirably uniformly heats a wafer 17 upon which epitaxial growth is sought. Optionally, the reactor can be provided with means for wafer rotation (not shown) such as are described by P. M. Frijlink in J. Crystal Growth, 93, p. 207 (1988).

In operation, a carefully cleaned wafer 17 is placed on susceptor 12, the vessel 10 is evacuated to a pressure of about 20 mbar, and the susceptor is gradually heated to a temperature of 500°C to 700°C-- preferably about 640°C. Metalorganic and hydride reactants are introduced into cell 11, mixed and caused to flow horizontally into a heated deposition zone defined by the top and side walls of the cell 11 and the top surface of susceptor 12 including heated wafer 17.

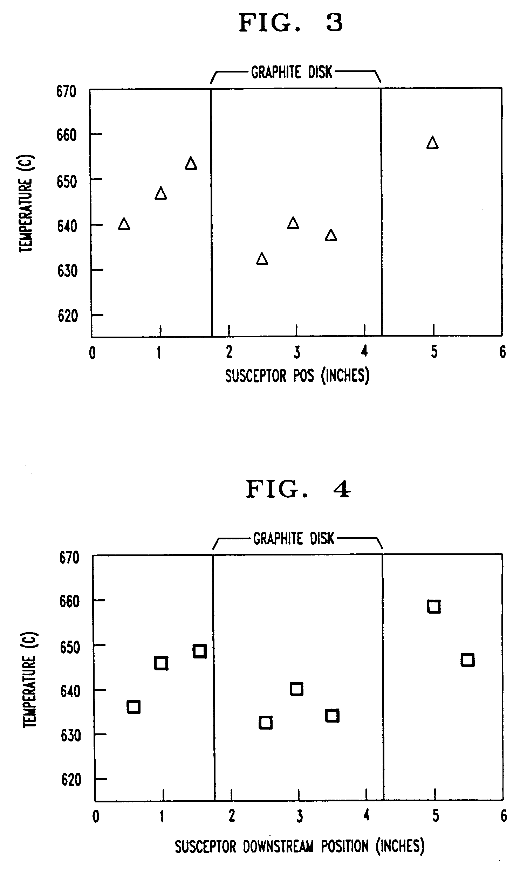

A difficulty with the MOCVD process using such apparatus is nonuniform heating of the wafer. FIG. 3 shows the longitudinal temperature profile of a susceptor including a nonrotating graphite disc of diameter 2.5 inches and thickness 5 min. As can be seen, there is a large temperature gradient, $\Delta T > 25°C$, between the upstream edge of the disc ($X = 1.75$) and its center at ($X = 3.0$). Large gradients are also observed across the disc in the lateral direction (not shown).

Rotation of the graphite disc does not eliminate this nonuniformity. FIG. 4 shows the longitudinal temperature profile of the same susceptor wherein the graphite disc is rotated at 115 rpm. Although rotation has reduced the difference between points located the same radial distance from the center of the disc, no improvement in temperature uniformity is observed compared to the case with no rotation.

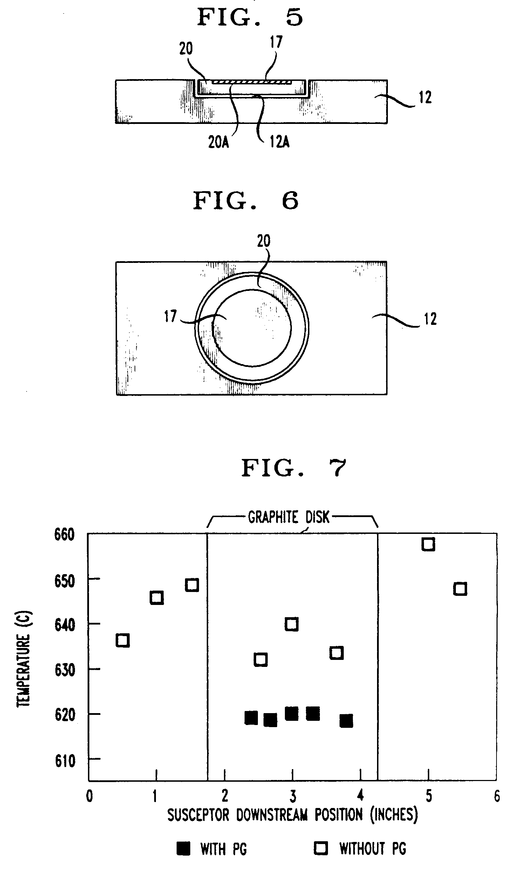

The conventional apparatus and process for growing an epitaxial layer can be modified by thermally coupling a major surface of the wafer to the high conductivity surface of a thermally anisotropic susceptor disc. FIGS. 5 and 6 show side and top views, respectively, of a preferred apparatus wherein a rotatable disc 20 of thermally anisotropic material such as pyrolytic graphite or pyrolytic boron nitride is disposed on the main susceptor block 12, and the wafer 17 is disposed in thermal contact with the disc. The main susceptor block 12 can be ordinary graphite. Preferably disc 20 and susceptor block 12 are provided with respective recessed regions 20A and 12A so that the susceptor block surface, the exposed disc surface, and the exposed wafer surface are all coplanar. Advantageously, gas flow means (not shown), such as are described in the above-cited Frijlink article, are provided for rotating the susceptor disc. The disc 20 can be 66 mm in diameter and 5 mm in thickness.

Pyrolytic graphite, the preferred anisotropic material, is commercially available from Union Carbide Corporation. In contrast with ordinary graphite which is substantially isotropic in its thermal properties, pyrolytic graphite has a thermal conductivity in a high conductivity plane which is three times greater than that of ordinary ATJ-grade graphite used in conventional susceptors. Moreover in the direction transverse to the high conductivity plane pyrolytic graphite has a thermal conductivity 200 times lower. The combination of high surface conductivity and low transverse conductivity produces a disc having a high degree of temperature uniformity. Thus, a wafer thermally coupled to the disc has enhanced temperature uniformity.

FIG. 7 is a graphical illustration comparing the temperature uniformity of a susceptor having a rotatable pyrolytic graphite disc (with PG) with one having a rotatable disc of ordinary graphite (without PG). As can be seen, the temperature uniformity of the pyrolytic graphite disc is superior to that of the ordinary graphite disc, and the pyrolytic graphite disc has a temperature profile uniform to within ±2°C across the entire area of the disc.

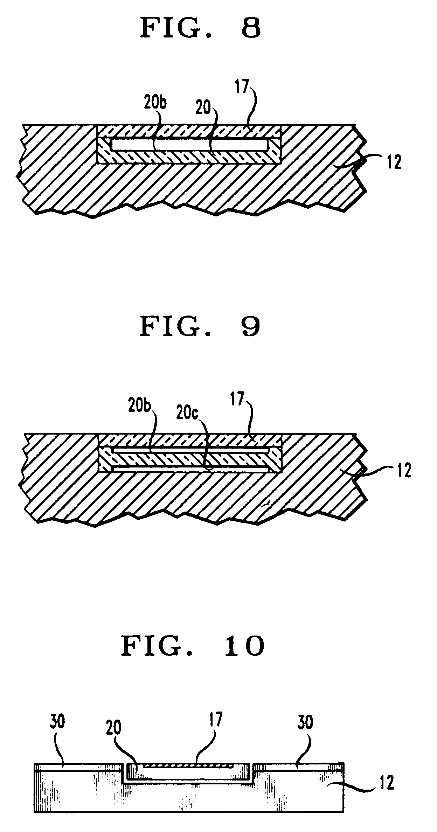

FIGS. 8 and 9, illustrate alternative embodiments of apparatus for thermally coupling the wafer to the high conductivity surface of an anisotropic susceptor disc. In FIG. 8 the anisotropic susceptor disc 20 is provided with a recessed region 20b so that the disc is adjacent the wafer but contacts the wafer 17 only at a limited peripheral area. Preferably the depth of recess is about one millimeter. Here the anisotropic susceptor disc is thermally coupled to the wafer by radiation.

In FIG. 9 the anisotropic susceptor disc 20 is adjacent both the wafer 17 and the main susceptor block 12 but is provided with recessed regions 20b and 20c so that disc 20 contacts both wafer 17 and block 12 only at limited areas. Thus the anisotropic susceptor disc is coupled to both the main susceptor block and to the wafer by radiation.

FIG. 10 is alternative embodiment similar to that of FIGS. 5 and 6 except that a second body 30 of thermally anisotropic material is disposed around the periphery of disc 20 in thermal contact with the main susceptor block 12. Body 30 is preferably twenty mils thick and preferably extends laterally beyond the peripheral edges of disc 20 by an inch or more. The advantage of this embodiment is that not only does body 20 provide a more uniform temperature across the wafer but also body 30 provides a more uniform temperature on the surface upstream from the wafer, reducing the sharp temperature gradient at the disc periphery shown in FIG. 7. Body 30 thus reduces growth nonuniformity attributable to thermally induced variations in gas flow or reaction rates.

It can now be seen that one can provide an improvement in epitaxial growth reactors of the type comprising a reduced pressure chamber, means for heating a wafer within the chamber and means for flowing reactant gases over the heated wafer for effecting epitaxial growth on the wafer. The improvement is that a body of thermally anisotropic material having a surface of relatively high thermal conductivity is thermally coupled to a major surface of the wafer. The body has a relatively low thermal conductivity transverse to the surface. The preferred anisotropic material is pyrolytic graphite, and thermal coupling can be effected by thermal contact or by radiation. In a preferred embodiment the body is a rotatable disc.

One can also provide an improvement in the method of epitaxial growth comprising the steps of heating a wafer in a reduced pressure environment and flowing reactant gases over the heated wafer. The improvement is heating the wafer by thermally coupling a major surface of the wafer to a high conductivity surface of a body of thermally anisotropic material. The thermal coupling can be by direct thermal contact or by radiation. The preferred anisotropic material is pyrolytic graphite.

While the invention was described in relation to metalorganic chemical vapor deposition it is equally applicable to any epitaxial growth process requiring a uniformly heated wafer for uniform deposition.

## Claims

1. In an epitaxial growth apparatus of the type comprising a chamber, means for heating a wafer within said chamber, and means for flowing reactant gas over said wafer for effecting epitaxial growth on the wafer, the improvement comprising a body of thermally anisotropic material having relatively high thermal conductivity across a surface and relatively low conductivity transverse to the surface, said body having said high conductivity surface thermally coupled to a major surface of said wafer.

2. The apparatus of claim 1 wherein said chamber is a reduced pressure chamber, said means for heating a wafer comprises means for heating a susceptor block and said means for flowing reactant gas comprise means for flowing a mixture of metal organic and hydride reactant gases.

3. The apparatus of claim 1 wherein said thermally anisotropic material is pyrolytic graphite.

4. The apparatus of claim 1 wherein said body of thermally anisotropic material is disposed for thermally contacting said wafer.

5. The apparatus of claim 1 wherein said body of thermally anisotropic material is disposed for thermally coupling to said wafer by radiation.

6. The apparatus of claim 2 wherein said body of anisotropic material is disposed in thermal contact with said susceptor.

7. The apparatus of claim 2 wherein said body of anisotropic material is disposed for thermally coupling to said susceptor by radiation.

8. The apparatus of claim 1 wherein said body of anisotropic material is rotatable.

9. The apparatus of claim 2 wherein a second body of thermally anisotropic material is disposed in thermal contact with said susceptor block, and said second body extends peripherally around the edges of said first body for providing a uniform surface temperature in the region upstream of said first body with respect to reactant gas flow.

10. In a method for effecting epitaxial growth on a wafer of the type comprising the steps of heating the wafer and flowing reactant gases over the heated wafer, the improvement wherein said wafer is heated by thermally coupling the wafer to a relatively high thermal conductivity surface of a body of thermally anisotropic material having a relatively low conductivity in the direction transverse to said surface.

11. The improved method of claim 10 wherein said heating of the wafer is effected by thermal contact with said surface.

12. The method of claim 10 wherein said heating of the wafer is effected by radiation from said surface.

13. The improved method of claim 10 wherein said thermally anisotropic material is pyrolytic graphite.

FIG. 1

(PRIOR ART)

REACTANTS
IN

INFRARED

FIG. 2

(PRIOR ART)

# FIG. 3

GRAPHITE DISK

TEMPERATURE (C)

SUSCEPTOR POS (INCHES)

# FIG. 4

GRAPHITE DISK

TEMPERATURE (C)

SUSCEPTOR DOWNSTREAM POSITION (INCHES)

# FIG. 5

# FIG. 6

# FIG. 7

# FIG. 8

# FIG. 9

# FIG. 10

**European Patent Office**

# EUROPEAN SEARCH REPORT

Application Number

EP 92 30 4604
PAGE1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-3 549 847 (THOMAS J. CLARK ET AL.)<br>* column 1, line 3 - line 17 *<br>* column 3, line 58 - column 4, line 18; figure 4 *<br>--- | 1-13 | C30B25/12<br>C23C16/44 |
| Y | PATENT ABSTRACTS OF JAPAN<br>vol. 11, no. 212 (E-522)9 July 1987<br>& JP-A-62 035 514 ( FUJITSU LTD ) 16 February 1987 | 1-13 | |
| A | * abstract *<br>--- | 1,10 | |
| O,Y | JOURNAL OF CRYSTAL GROWTH.<br>vol. 93, no. 1-4, November 1988, AMSTERDAM NL<br>pages 207 - 215;<br>P.M. FRIJLINK: 'A new versatile large size MOVPE reactor'<br>* page 207, paragraph 2 - page 209; figures 1,3 * | 2,6-9 | |
| A | --- | 1 | |
| A | US-A-4 599 069 (SHUNICHI MURAKAMI ET AL.)<br><br>* column 1, line 46 - line 56 *<br>* column 4, line 20 - column 6, line 23; claims 1,2; figures 1-5 *<br>--- | 1,3,4,6,<br>9-11,13 | TECHNICAL FIELDS SEARCHED (Int. Cl.5)<br><br>C30B<br>C23C<br>F27D<br>H01L |
| A | PATENT ABSTRACTS OF JAPAN<br>vol. 15, no. 221 (C-838)6 June 1991<br>& JP-A-3 065 590 ( NEC CORP. ) 20 March 1991<br>* abstract *<br>--- | 1-4,6,<br>9-11,13 | |
| A | GB-A-1 305 454 (SCHUNK & EBE GMBH)<br><br>* page 1, line 37 - line 57; claims 1,3,6 *<br>---<br>-/-- | 1-4,6,<br>10,11,13 | |

The present search report has been drawn up for all claims

| Place of search | Date of completion of the search | Examiner |
|---|---|---|
| BERLIN | 26 AUGUST 1992 | KLOPFENSTEIN P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P0401)

European Patent
Office

EUROPEAN SEARCH REPORT

Application Number

EP    92 30 4604
PAGE2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | JOURNAL OF CRYSTAL GROWTH. vol. 94, no. 4, April 1989, AMSTERDAM NL pages 901 - 910; A.G. THOMPSON ET AL.: 'Growth of GaAs in a rotating disk MOCVD reactor' * page 902, paragraph 3.1 - page 903, paragraph 3.2; figure 1 * | 1,2,10 | |

-----

**TECHNICAL FIELDS SEARCHED (Int. Cl.5 )**

The present search report has been drawn up for all claims

| Place of search | Date of completion of the search | Examiner |
|---|---|---|
| BERLIN | 26 AUGUST 1992 | KLOPFENSTEIN P. |

EPO FORM 1503 03.82 (P0401)